(19) Europäisches Patentamt
European Patent Office
Office européen des brevets

(11) **EP 3 189 590 B1**

(12) **EUROPÄISCHE PATENTSCHRIFT**

(45) Veröffentlichungstag und Bekanntmachung des Hinweises auf die Patenterteilung:
**17.01.2024   Patentblatt 2024/03**

(21) Anmeldenummer: **15745498.4**

(22) Anmeldetag: **05.08.2015**

(51) Internationale Patentklassifikation (IPC):
**H03H 9/54** *(2006.01)*    **H03H 9/56** *(2006.01)*
**H03H 9/60** *(2006.01)*    **H03H 9/64** *(2006.01)*

(52) Gemeinsame Patentklassifikation (CPC):
**H03H 9/6483; H03H 9/542; H03H 9/568; H03H 9/605**

(86) Internationale Anmeldenummer:
**PCT/EP2015/068064**

(87) Internationale Veröffentlichungsnummer:
**WO 2016/034357 (10.03.2016 Gazette 2016/10)**

(54) **FILTER MIT VERBESSERTER LINEARITÄT**

FILTER WITH IMPROVED LINEARITY

FILTRE À LINÉARITÉ AMÉLIORÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.09.2014   DE 102014112676**

(43) Veröffentlichungstag der Anmeldung:
**12.07.2017   Patentblatt 2017/28**

(73) Patentinhaber: **SnapTrack, Inc.**
**San Diego, CA 92121 (US)**

(72) Erfinder: **FREISLEBEN, Stefan**
**85579 Neubiberg (DE)**

(74) Vertreter: **Bardehle Pagenberg Partnerschaft mbB**
**Patentanwälte Rechtsanwälte**
**Prinzregentenplatz 7**
**81675 München (DE)**

(56) Entgegenhaltungen:
EP-A2- 1 209 807        EP-A2- 1 478 091
EP-A2- 1 544 997        EP-A2- 2 141 805
WO-A1-2010/100148        US-A1- 2002 140 519
US-B1- 8 701 065        US-B2- 8 310 321

• ALIOUANE S ET AL: "RF-MEMS switchable inductors for tunable bandwidth BAW filters", DESIGN AND TECHNOLOGY OF INTEGRATED SYSTEMS IN NANOSCALE ERA (DTIS), 2010 5TH INTERNATIONAL CONFERENCE ON, IEEE, PISCATAWAY, NJ, USA, 23 March 2010 (2010-03-23), pages 1-6, XP031691411, ISBN: 978-1-4244-6338-1

**Beschreibung**

Intermodulation (IM oder IMD) bezeichnet in der Nachrichtentechnik und Elektroakustik die Entstehung unerwünschter spektraler Anteile durch nichtlineare Übertragungsfunktionen von Schaltungsteilen, wenn mindestens zwei unterschiedliche Frequenzen verarbeitet werden müssen. Da solche Intermodulationsprodukte zu unerwünschten Signalen und damit zu Störungen in einem genutzten Frequenzbereich führen können, ist man stets bemüht, das Entstehen von störenden Intermodulationsprodukten zu vermeiden.

Weiter können sich bei der Generation von HF Signalen immer auch Harmonische ausbilden, deren Frequenzen bei einem nicht unbedingt geradzahligen Vielfachen der Grundmode liegen. Solche Harmonischen sind zwar weit genug von der Grundmode entfernt, können aber in anderen Bändern stören. Generell können Harmonische auch als Intermodulationsprodukte zweier Frequenzen f1 und f2 für den Spezialfall f1=f2 angesehen werden.

Es existieren Intermodulationsprodukte/Harmonische zweiter, dritter und noch höherer Ordnung, die sich durch die Faktoren bzw. deren Summe unterscheiden, mit denen die Grundfrequenzen in die Mischprodukte eingehen.

Zur Vermeidung von Intermodulationsprodukten und von störenden Harmonischen versucht man zum Einen, die Linearität von Bauelementen und Schaltungsteilen zu erhöhen. Wo dies nicht gelingt, kann versucht werden, die Spannung über dem nichtlinearen Bauelement zu reduzieren, um den Bereich zu vergrößern, in dem das Schaltungselement linear arbeitet.

Im Bereich der Filtertechnik und dort insbesondere bei Reaktanzfiltern, die aus einem Netzwerk serieller und paralleler Resonatoren aufgebaut sind, können Intermodulationsprodukte durch Kaskadierung mehrerer Resonatoren unterdrückt, aber nie ganz vermieden werden. Ein Nachteil der Kaskadierung besteht darin, dass die für das Filter erforderliche statische Kapazität bei einer Verschaltung von Resonatoren, also einer Kaskade von Resonatoren, nur durch Vergrößerung der Grundflächen der einzelnen Kondensatoren bzw. Resonatoren beibehalten und eingestellt werden kann. Dies führt dazu, dass der Flächenbedarf von Resonatorfiltern mit zunehmender Kaskadierung zu groß und die Kaskadierung somit unwirtschaftlich wird. Zudem wirkt dies dem Erfordernis der Miniaturisierung entgegen.

Ein weiterer Nachteil besteht darin, dass mit zunehmender Kaskadierung ein Sättigungseffekt eintritt, sodass trotz Hinzufügens weiterer Resonatoren zur Kaskade immer weniger Effekt erzielt wird bzw. die zusätzlich erreichbare Unterdrückung von Intermodulationsprodukten und auch von Harmonischen mit jedem weiteren Resonator immer geringer wird.

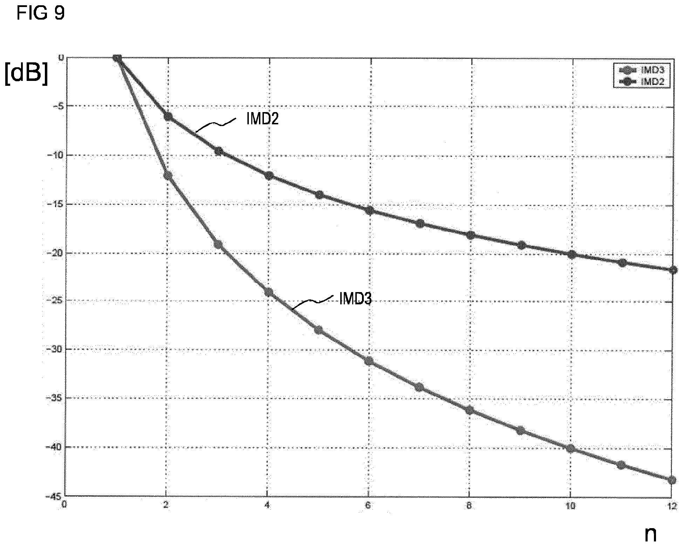

In Figur 9 ist dargestellt, wie sich die Unterdrückung von Intermodulationsprodukten zweiter Ordnung (IMD2) und dritter Ordnung (IMD3) in Abhängigkeit vom Grad n der Kaskadierung verhält, wobei n die Anzahl in Serie verschalteter Resonatoren ist. Die zunehmend flacher abfallenden Kurven lassen die Sättigung gut erkennen. Dies zeigt, dass Kaskadierung nur bis zu einem bestimmten Grad technisch und wirtschaftlich sinnvoll ist.

Die EP 1 478 091 A2 betrifft eine Filtervorrichtung mit scharfer Dämpfungscharakteristik in schmaler Bandbreite und Verzweigungsfilter mit einer solchen Vorrichtung.

Ähnlich betrifft auch die WO 2010/100148 A1 ein Reaktanzfilter, wobei vorgeschlagen wird, die obere Flanke des Durchlassbereichs mithilfe eines Kondensators zu versteilen, der parallel zu mindestens einem der Reihenresonatoren des Reaktanzfilters geschaltet ist.

Die EP 2 141 805 A2 betrifft eine Resonatorvorrichtung, die eine Vielzahl von Resonatoren umfasst, die in Reihe geschaltet sind. Eine Induktivität und ein Kondensator sind parallel zu mindestens einem der Vielzahl von Resonatoren geschaltet. Zu mindestens einem anderen der Mehrzahl von Resonatoren ist keine Induktivität und kein Kondensator parallel geschaltet.

Die US 8,310,321 B2 betrifft ein einstellbares Filter, das eine Schaltungskonfiguration enthält, in der Kondensatoren mit akustischen Oberflächenwellenresonatoren verbunden sind.

Die US 8,701,065 B1 offenbart ein Verfahren zum Entwerfen eines akustischen Mikrowellenfilters. Das Verfahren umfasst das Auswählen einer Anzahl von Filterabschnitten und das Kaskadieren der ausgewählten Anzahl von Filterabschnitten, um ein kaskadiertes Filterschaltungsdesign zu erzeugen. Das Verfahren umfasst ferner das Hinzufügen von parasitären Effekten zu dem kaskadierten Filterschaltungsentwurf, um einen voroptimierten Filterschaltungsentwurf zu erzeugen.

Die EP 1 209 807 A2 betrifft eine Filterstruktur und -anordnung mit piezoelektrischen Resonatoren, die in Serie geschaltet sind.

Die US 2002/0140519 A1 betrifft einen Antennenduplexer, der einen Eingangsanschluss enthält, sowie ein Sendefilter mit einem akustischen Oberflächenwellenfilter, dessen Eingangsanschluss mit dem Eingangsanschluss verbunden ist, einen Phasenschieber, dessen Eingangsanschluss mit einem Ausgangsanschluss des Sendefilters verbunden ist, ein Empfangsfilter, dessen Eingangsanschluss mit einem Ausgangsanschluss des Phasenschiebers verbunden ist, einen Ausgangsanschluss, der mit dem Ausgangsanschluss des Empfangsfilters verbunden ist, und einen Antennenanschluss, der zwischen dem Sendefilter und dem Phasenschieber angeschlossen ist.

Die EP 1 544 997 A2 betrifft ein Oberflächenwellenfilter, das Oberflächenwellenresonatoren enthält, die in einer Leiterstruktur mit Serien- und Parallelresonatoren verbunden sind.

Der Artikel "RF-MEMS Switchable Inductors for Tunable Bandwidth BAW Filters" von S. Aliouane und A. B. Kouki betrifft im Allgemeinen eine Methode zur Rekonfiguration der Bandbreite von Bulk Acoustic Wave (BAW)-Leiterfiltern durch Hinzufügen von schaltbaren Induktoren. Die Induktivitätswerte werden durch die Auswahl der Windungszahl in der Spiralinduktivität mithilfe von mikroelektromechanischen (MEMS) Schaltern gesteuert.

Aufgabe der vorliegenden Erfindung ist es, eine Filterschaltung anzugeben, die eine verbesserte Linearität und daher eine verbesserte Unterdrückung von Intermodulationsprodukten und Harmonischen aufweist. Außerdem soll die verbesserte Filterschaltung mit einer maßvollen Erhöhung der Resonatorflächen realisierbar sein.

Diese Aufgabe wird erfindungsgemäß durch eine Filterschaltung mit den Merkmalen von Anspruch 1 gelöst. Vorteilhafte Ausgestaltungen der Erfindung sind den weiteren Ansprüchen zu entnehmen. Nur die Ansprüche definieren die Erfindung. Sofern die Beschreibungen im Folgenden Filterschaltungen betreffen, die nicht zumindest gemäß Anspruch 1 ausgestaltet sind, sind sie dennoch für das Verständnis der Erfindung hilfreich.

Die Filterschaltung umfasst ein erstes als Reaktanzfilter ausgebildetes Filter. Ein solches Filter umfasst einen seriellen Signalpfad (Serienzweig), der zwischen einem ersten Filterport und einem zweiten Filterport gekoppelt ist. Von Schaltungsknoten, die im seriellen Signalpfad angeordnet sind, zweigt jeweils ein Parallelzweig ab, der den Schaltungsknoten mit einem Festpotenzial verbindet. Im Serienzweig und jedem der Parallelzweige ist zumindest ein Resonator oder eine Verschaltung von Resonatoren angeordnet.

Das Reaktanzfilter beginnt an einem Schaltungsport mit einem Resonator im Serienzweig.

Im ersten Parallelzweig, der mit einem einem der Filterports am nächsten angeordneten Schaltungsknoten verbunden ist, und einem Filterport direkt benachbart im Serienzweig sind mehrere Resonatoren in Serie verschaltet, wobei ein Kondensator in Serie oder parallel zu der Serienverschaltung von mehreren Resonatoren im Serienzweig verschaltet ist, wobei im ersten Fall eine Spannungsteilung und im zweiten Fall eine Stromteilung resultiert.

Grundlegende Idee der Erfindung ist es also, eine Spannungsteiler- oder Stromteilerschaltung vorzusehen, die zumindest ein lineares Element umfasst. Der genannte Kondensator ist ein bevorzugtes lineare Element , doch sind auch andere lineare Elemente, die zum Teilen der Spannung geeignet sind, möglich. Auf diese Weise gelingt es, den eingangs beschriebenen Sättigungseffekt zu reduzieren, der anderenfalls dazu führt, dass mit zunehmendem Kaskadierungsgrad, also mit zunehmender Anzahl in Serie verschalteter Resonatoren, immer weniger Effekt bei der Vermeidung von Intermodulationsprodukten beobachtet wird. Der Kondensator hat darüber hinaus den Vorteil, dass der mit ihm erzielte Spannungs- oder Stromteilereffekt relativ breitbandig arbeitet und damit über einen weiten Frequenzbereich einsetzbar ist. Im Fall von Spannungsteilung gilt: Je größer die Spannung ist, die am linearen Element abfällt, umso größer ist der Effekt, also die Reduzierung von Intermodulationsprodukten. Je kleiner die Kapazität des Kondensators im Vergleich zur gesamten Kapazität im Serien- oder Parallelzweig ist, desto größer ist der Effekt und desto stärker wird das Auftreten von Intermodulationsprodukten und Harmonischen verhindert.

Ein Kondensator, der parallel zu der Verschaltung von Resonatoren, also zu der Kaskade seriell verschalteter Resonatoren geschaltet ist, dient als Stromteiler. Auch hier gilt, je mehr Strom über ein lineares Element fließt und damit je weniger Strom über nichtlineare Elemente fließt, desto weniger Intermodulationsprodukte/Harmonische treten erfindungsgemäß auf.

Das lineare Element wirkt prinzipiell unabhängig davon, wo es in der Filterschaltung eingesetzt wird. Den größten Effekt hat es jedoch in Serie oder parallel zu denjenigen Resonatoren, die demjenigen Filterport am nächsten sind, an dem zumindest ein Signal in den Signalpfad einwirkt oder einkoppelt, das an nichtlinearen Elementen mit sich selbst oder mit einer anderen Systemfrequenz Intermodulationsprodukte und Harmonische bilden kann. Dieser Filterport kann der Filtereingang oder der Filterausgang sein, da die Einkopplung abhängig von der gesamten Schaltungsumgebung ist und daher kundenspezifisch und unabhängig von der Filterschaltung als solche. Ein lineares Element ist daher erfindungsgemäß auf jeden Fall mit diesem "ersten" Resonator verschaltet. Der "erste" Resonator ist ein serieller Resonator.

Ein linearer Kondensator lässt sich in einfacher Weise als Plattenkondensator zusammen mit den Resonatoren auf einem gemeinsamen Substrat realisieren. Möglich ist es jedoch auch, den Kondensator als externes diskretes Element mit den Resonatoren zu verschalten. Dabei weist jedoch die Integration auf dem gemeinsamen Substrat die größeren Vorteile auf. Gegenüber einer Induktivität, die ebenfalls mit den Resonatoren als Rückkopplungselement verschaltet werden kann, weist der Kondensator den Vorteil auf, dass mit ihm keine zusätzlichen Resonanzen und damit keine zusätzlichen Störungen im Übertragungsverhalten des Filters auftreten können und dass mit dem Kondensator der Spannungs- oder Stromteilereffekt breitbandiger bewirkt werden kann.

Ein Nachteil der vorgeschlagenen Filterschaltung besteht darin, dass sich durch die Spannungs- oder Stromteilung der Polnullstellenabstand der Resonatoren verringert, was sich direkt auf die Bandbreite des Filters auswirkt. Durch Optimierung des Filters kann zwar die gewünschte Bandbreite eingestellt werden, jedoch müssen dabei als Nachteil in Kauf genommen werden, dass sich das Filterverhalten sowohl im Passband, insbesondere das VSWR, als auch im nahen Stoppband leicht verschlechtern kann.

Eine Filterschaltung, die ein erfindungsgemäß optimiertes erstes Filter aufweist, stellt daher einen Trade-off zwischen einem guten Übertragungsverhalten/VSWR und einer Reduzierung von Intermodulationsprodukten/Harmonischen dar. Es muss also abgewogen werden, ob lieber störende Intermodulationsprodukte/Harmonische vermieden werden soll oder ob mehr Wert auf ein optimiertes Übertragungsverhalten/VSWR gelegt wird.

Ein positiver Effekt wird jedoch bereits erzielt, wenn im ersten Serien- oder Parallelzweig ein einzelner Resonator in Serie mit oder parallel zu einem Kondensator geschaltet wird. Die statische Kapazität des Resonators und die Kapazität des Kondensators ergeben zusammen die Gesamtkapazität des Serien- oder Parallelzweigs. Beide zusammen müssen beim Filterdesign beachtet werden.

In einer bevorzugten Ausführung werden die Resonatoren als mit akustischen Wellen arbeitende Resonatoren ausgelegt. Für die Filterschaltung bzw. das erste Filter der Filterschaltung sind daher Resonatoren auf SAW-, FBAR oder BAW-Basis (Surface Acoustic Wave, Thin Film Bulk Acoustic Wave bzw. Bulk Acoustic Wave) geeignet. Auch GBAW (Guided Bulk Acoustic Wave) Resonatoren, mit geführten Volumenwellen arbeitende Resonatoren, sind geeignet. In allen Fällen kann die Kapazität der Resonatoren über die Resonatorfläche eingestellt werden. Die Resonatorfläche eines BAW-Resonators ergibt sich dabei als Überlappungsfläche zwischen erster und zweiter plattenförmiger Elektrode, insbesondere soweit dazwischen ein piezoelektrisches Material angeordnet ist. Bei SAW-Resonatoren ist die Kapazität abhängig vom Produkt der Apertur der Resonatoren und der Anzahl der Elektrodenfinger im Resonator.

Prinzipiell können die Resonatoren jedoch auch als LC-Resonatoren ausgeführt sein, bei denen sich ebenfalls durch Verschaltung mit einem Kondensator im Parallelzweig oder parallel zum Parallelzweig eine Reduzierung von Intermodulationsprodukten/Harmonischen erreichen lässt.

Die Verschaltung von Resonatoren im ersten Parallelzweig umfasst eine Serienverschaltung von vier bis acht Resonatoren. Mit dieser Anzahl wird ein gutes Übertragungsverhalten bei ausreichender Dämpfung von Intermodulationsprodukten/Harmonischen bei vertretbarem Flächenbedarf erreicht.

Außerdem ist ein weiterer Kondensator in Serie zu einem Parallelzweig verschaltet. Dieser weitere Kondensator führt zu einer weiteren Verminderung des Spannungsabfalls an den einzelnen nichtlinearen Elementen, wohingegen der Kondensator selbst ein weitgehend lineares Element darstellt. Auch auf diese Weise werden Intermodulationsprodukte/Harmonische weiter reduziert.

Auch der weitere Kondensator ist möglichst nahe an demjenigen Filterport angeordnet, über den eines der zu Störungen oder Intermodulationsprodukten führendes Signal eingekoppelt wird.

Ist ein Resonator ein Serienresonator, so bedeutet "Parallelschaltung" zu diesem Serienresonator, dass ein Kondensator in einem parallelen Serienpfad angeordnet ist, der vor und nach dem seriellen Resonator mit einem Schaltungsknoten des Seitenzweigs verbunden ist.

Ist ein Resonator ein Parallelresonator, so ist ein Kondensator vorzugsweise in einem Parallelzweig angeordnet, der dem Parallelzweig mit dem Resonator unmittelbar benachbart ist und daher insbesondere an den gleichen Schaltungsknoten im seriellen Signalpfad angebunden ist wie der Parallelzweig mit dem Resonator.

In einer vorteilhaften Ausgestaltung ist das erste Filter ein Empfangsfilter einer Filterschaltung, die mehrere Sendezweige umfasst, die mit dem Filtereingang oder dem Filterausgang gekoppelt sind. Da die Sendezweige zum Senden in unterschiedlichen Frequenzbändern ausgelegt sind, können einer solchen Filterschaltung prinzipiell Intermodulationsprodukte auftreten, die bei ungünstiger Konstellation innerhalb des Passbands des Empfangsfilters auftreten können. Das Verkoppeln unterschiedlicher Frequenzen bzw. das Einkoppeln von Frequenzen außerhalb des Nutzsignals in ein Filter kann auf einem kapazitiven, induktiven, resistiven oder elektromagnetischen Weg erfolgen und kann nicht vollständig vermieden werden. Die weitere Folge der Einkopplung, das Auftreten von Intermodulationsprodukten/Harmonischen in Folge nicht-linearer Elemente, kann dagegen mit der Erfindung reduziert werden.

In einer weiteren Ausgestaltung ist das erste Filter als Empfangsfilter ausgelegt. Es kann Teil einer Filterschaltung sein, die weitere Sende- und/oder Empfangszweige umfasst.

Das erste Filter kann auch Teil eines Duplexers oder eines Multiplexers sein, der Teil einer Filterschaltung mit mehreren Sendezweigen ist, deren Signale potentiell in den Signalpfad des Filters einkoppeln können.

In weiterer Ausgestaltung der Erfindung umfasst das erste Filter weitere Kondensatoren, die vor dem ersten Resonator, nach dem letzten Resonator und zusätzlich zwischen einzelnen oder zwischen immer jeweils zwei im Signalpfad angeordneten Resonatoren bzw. zwischen allen im Signalpfad angeordneten Verschaltungen von Resonatoren vorgesehen werden können. Weitere Kondensatoren können parallel zu Resonatoren oder kaskadierten Verschaltungen von Resonatoren geschaltet sein.

Das erste Filter kann ausschließlich Resonatoren als Filterelemente umfassen. Möglich ist es jedoch auch, im Signalpfad ein DMS-Filter in Serie zu verschalten. Dies wird in einfacher Weise dadurch verwirklicht, dass ein Schaltungsknoten innerhalb des seriellen Signalpfads mit dem Eingang des DMS-Filters und ein weiterer Schaltungsknoten mit dem Ausgang des DMS-Filters verbunden wird. Das DMS-Filter ist jedoch vorzugsweise nicht direkt dem Filtereingang benachbart, sondern zwischen zwei Resonatoren bzw. zwischen zwei Verschaltungen von Resonatoren im seriellen Signalpfad angeordnet.

Wie bereits erwähnt, zeichnet sich eine Ausführungsform mit auf dem Filtersubstrat integrierten Kondensatoren besonders vorteilhaft aus. Dabei sind die Resonatoren als mit akustischen Wellen arbeitende Resonatoren ausgebildet und auf einem gemeinsamen Chip angeordnet. Auf dem gleichen Chip sind Kondensatoren als Plattenkondensatoren realisiert. Ein jeder solcher Plattenkondensator weist zwei flächig ausgeformte Kondensatorelektroden und eine dazwischen angeordnete Dielektrikumsschicht auf. Flächig ausgeformt bedeutet dabei, dass der Querschnitt gegenüber dem einer Leiterbahn erheblich erhöht ist.

Für eine bessere Integrierbarkeit ist es von Vorteil, wenn die Dielektrikumsschicht zusammen mit einer weiteren Funktionsschicht des Chipbauelements in einem gemeinsamen Herstellungsschritt erzeugt wird. Auf diese Weise kann ein Verfahrensschritt genutzt werden, der bereits bei der Herstellung bekannter Filter benötigt wird, um den erfindungsgemäßen Kondensator bzw. das Dielektrikum des Kondensators abzuscheiden bzw. zu erzeugen.

In der Regel bedeutet die gemeinsame Herstellung der Funktionsschicht und der Dielektrikumsschicht, dass beide das gleiche Material und die gleiche Schichtdicke aufweisen. Möglich ist es jedoch auch, nachträglich die Funktionsschicht oder die Dielektrikumsschicht in einem zusätzlichen Verfahrensschritt aufzudicken oder in der Schichtendicke wieder zu reduzieren. In allen Fällen ist es wichtig, einen Kondensator mit möglichst hoher Linearität zu erzeugen, der sich insbesondere durch eine hohe Schichtdickenkontrolle auszeichnet.

Eine Ausführungsform weist als Dielektrikum ein organisches Polymer auf, das an anderer Stelle im ersten Filter bzw. in der Filterschaltung zur Isolation von Leiterbahnen im Kreuzungsbereich zweier Leiterbahnen genutzt wird. Ein bewährtes und vorteilhaft einsetzbares Material sind dabei Polymere auf der Basis von BCB (Benzocyclobutan) und dessen Abkömmlingen. Dieses für Halbleiterschaltungen bewährte Material weist eine niedrige Dielektrizitätskonstante auf und lässt sich in einfacher Weise in Standardprozessen mit hoher Schichtdickengleichmäßigkeit erzeugen.

In einer weiteren Ausführung wird als Dielektrikumsschicht ein Material eingesetzt, welches bei bekannten Filtern zur Kompensation eines zu hohen Temperaturgangs der Mittenfrequenz, also eines zu hohen Temperaturkoeffizienten der Mittenfrequenz eingesetzt wird. Üblicherweise wird dafür eine Schicht eines Materials mit einem positiven Temperaturkoeffizienten der mechanischen Eigenschaften eingesetzt, insbesondere $SiO_2$. Erfindungsgemäß kann diese $SiO_2$-Schicht daher als Dielektrikumsschicht für den Kondensator genutzt werden, wobei deren Schichtdicke entweder optimiert sein kann, um einen optimalen Kapazitätswert des Kondensators bereitzustellen oder eine optimale Kompensation des Temperaturkoeffizienten oder ein Trade-off davon zu erzielen.

Allgemein können zu diesem Zweck auch andere Materialien eingesetzt werden, die einen positiven Temperaturkoeffizienten der mechanischen Eigenschaften aufweisen. Nach dem Erzeugen der Dielektrikumsschicht muss anschließend noch die obere Kondensatorelektrode über der Dielektrikumsschicht aufgebracht werden.

In einer weiteren Ausführung wird vorteilhaft auch für die Elektroden des Plattenkondensators ein Material bzw. ein Verfahrensschritt genutzt, die bereits an anderer Stelle im Filter bzw. im Verfahren eingesetzt werden.

So kann z.B. die untere Elektrode des Kondensators aus der Metallisierung eines als Resonator eingesetzten SAW-Eintorresonators gebildet werden. Die obere Elektrode des Kondensators kann z.B. zusammen mit einer Padaufdickung ausgebildet werden, die über den Anschlusspads des Filters erzeugt ist

Es ist möglich, dass der linearisierende Kondensator übliche Elektrodenstrukturen eines elektroakustischen Resonators umfasst. Dann kann der Kondensator in seiner Resonanzfrequenz verstimmt sein. Es ist auch möglich, dass z. B. ein quasi-SAW-Resonator oder ein quasi-GBAW-Resonator so gegenüber den Kristallachsen des Substrats verdreht ist, dass sein elektroakustischer Kopplungskoeffizient $\kappa^2$ ausreichend gering ist.

In einer erfindungsgemäßen Filterschaltung zeigen diejenigen Kondensatoren den größten Effekt, die dem Filterport am nächsten angeordnet sind, über den zumindest eines der zu Intermodulationsprodukten oder Harmonischen führenden Signale eingekoppelt wird. Das Gleiche gilt für die Kaskadierung von Resonatoren, die vorzugsweise ebenfalls insbesondere bei denjenigen Resonatoren vorgenommen wird, die dem Filtereingang oder einem anderen Filterport direkt oder nahe benachbart sind.

Eine vorteilhafte Filterschaltung weist daher Resonatoren und Verschaltungen mehrerer Resonatoren auf, wobei in einer Ausführung die Verschaltung mehrerer Resonatoren kaskadierte Resonatoren umfasst und der Kaskadierungsgrad der Resonatoren und der Filterschaltung mit zunehmender Entfernung vom Filtereingang abnimmt. Auf diese Weise ist es möglich, den bei zunehmender Kaskadierung parallel erhöhten Flächenbedarf der Filterschaltung zu begrenzen.

Ein erfindungsgemäßes Filter kann eine optimierte Anzahl von Parallelzweigen umfassen. Vorteilhaft sind im Filter 2-7, insbesondere 2-4 Parallelzweige vorgesehen.

Ein erfindungsgemäßes Filter kann eine optimierte Anzahl von Serienelementen umfassen. Ein Serienelement ist ein Serienresonator, eine Verschaltung von Serienresonatoren oder ein anderes Element wie z.B. ein DMS Filter oder eine DMS-Teilstruktur. Auch ein Kondensator kann Teil eines Serienelements sein. Ein Serienelement ist beiderseits von Schaltungsknoten begrenzt. Je ein Serienelement kann zwischen dem Filtereingang und dem ersten Schaltungsknoten oder zwischen dem Filterausgang und dem Filterausgang angeordnet sein. Vorteilhaft sind 2-6 Serienelemente vorgesehen.

Es ist nicht nötig, ein linearisiendes Element zu jedem Resonator oder Serienzweig oder Parallelzweig hinzuzufügen. Im Wesentlichen genügt es, das Element, z. B. einen linear arbeitenden Kondensator, dort zu verschalten, wo die Wirkung am größten ist. Je nachdem, ob das ursprüngliche Signal und/oder das Störsignal in einem Passband liegen oder nicht, kann die ideale Position des Elements innerhalb der Schaltungstopologie variieren.

Im Folgenden wird die Erfindung anhand von Figuren näher erläutert, welche aber nicht unbedingt alle Elemente der Erfindung zeigen. Sie sind aber dennoch nützlich, um die Erfindung zu verstehen. Sofern die Figuren Filter und Filterschaltungen darstellen, sind diese nur schematisch ausgeführt. Dies bedeutet auch, dass jede der dargestellten Filterschaltungen weitere Elemente umfassen kann, die nicht zwingend erforderlich sind, die aber für Filterschaltungen an sich bekannt zur weiteren Optimierung des Filters eingesetzt werden können. Es können auch Elemente weggelassen sein, die keine Rolle spielen.

Figuren 1A und 1B      zeigen Filterschaltungen mit je einem in einem Parallelzweig angeordneten Kondensator,

Figuren 1C und 1D      zeigen Filterschaltungen mit je einem in einem Serienzweig angeordneten Kondensator,

Figuren 1E      zeigt eine Filterschaltung mit einem Kondensator, der in einem parallelen Serienzweig angeordnet ist,

Figuren 2 und 3      zeigen Filterschaltungen mit je zwei Kondensatoren, die in einem Parallelzweig und zusätzlich im Signalpfad angeordnet sind, wobei die Kondensatoren im Signalpfad in Serie oder parallel zu Resonatoren verschaltet sind, und die Kondensatoren im Parallelzweig parallel zu Resonatoren verschaltet sind,

Figuren 4 und 5      zeigen Filterschaltungen mit je zwei Kondensatoren, die in einem Parallelzweig und zusätzlich im Signalpfad angeordnet sind, wobei die Kondensatoren im Signalpfad in Serie oder parallel zu Resonatoren verschaltet sind, und die Kondensatoren im Parallelzweig in Serie zu Resonatoren verschaltet sind,

Figur 6      zeigt eine Filterschaltung, die mehr als einen ersten und mehr als einen zweiten Kondensator im Parallel- und im Signalpfad umfasst,

Figur 7      zeigt eine Filterschaltung, die benachbart zum Filtereingang und/oder zum Filterausgang als zusätzliches Schaltungselement eine Induktivität im Signalpfad umfasst,

Figur 8      zeigt das Ergebnis verschiedener Simulationen, wie mit einer Filterschaltung nach Figur 7 das Auftreten eines Intermodulationsproduktes reduziert wird,

Figur 9      zeigt den Effekt der Reduzierung von Intermodulationsprodukten in Abhängigkeit vom Kaskadierungsgrad von in der Verschaltung verwendeten Resonatoren.

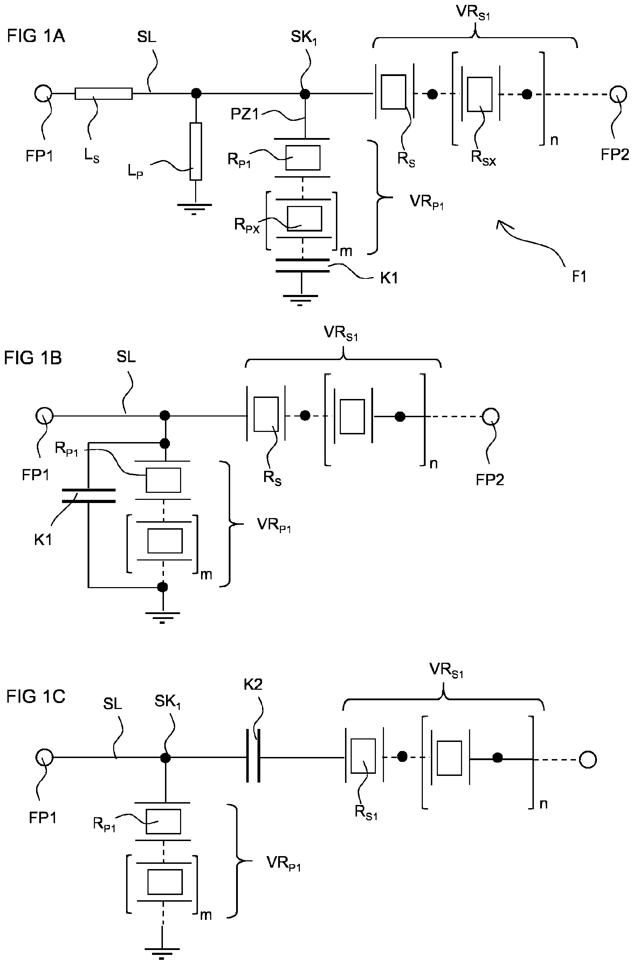

Figur 1A zeigt eine Filterschaltung. Dargestellt ist schematisch ein Filter einer Filterschaltung, in der eine serielle Signalleitung SL einen ersten Filterport Fp1 mit einem zweiten Filterport Fp2, die wahlweise Filterein- und - ausgang zugeordnet sein können, verbindet. In der Signalleitung SL ist ein serieller Resonator RS1 angeordnet. Wahlweise können in der Signalleitung SL noch n weitere Resonatoren RSX mit dem ersten seriellen Resonator RS1 verschaltet sein. N kann ganzzahlige Werte von Null bis ca. 10 annehmen. Die unmittelbar hintereinander in Serie geschalteten seriellen Resonatoren bilden eine erste Verschaltung von Resonatoren VRS1. Sämtliche Resonatoren RSX können unterschiedliche Kenngrößen wie Resonanzfrequenz oder statische Kapazität aufweisen.

Vor oder nach den seriellen Resonatoren können Schaltungsknoten SK vorgesehen sein, an die weitere Elemente, Filterzweige oder Signalleitungen angekoppelt sind. In Figur 1A zweigt von einem ersten Schaltungsknoten SK1 ein erster Parallelzweig PZ1 ab, der den ersten SchaltungsknotenSK1 mit einem Festpotenzial, hier mit Massepotenzial, verbindet. Im ersten Parallelzweig PZ1 ist ein erster paralleler Resonator RP1 angeordnet, der wahlweise mit einer Anzahl m weiterer in Serie geschalteter paralleler Resonatoren RPX in Reihe geschaltet ist. Der Wert m kann unabhängig von n gewählt werden und ähnliche Werte annehmen. Zusammen ergeben die parallelen Resonatoren eine Verschaltung VRP1. Zwischen der Verschaltung von parallelen Resonatoren und dem Festpotenzial ist ein erster Kondensator K1 in Reihe geschaltet. Auch diese Resonatoren RPX können untereinander und in Bezug auf RSX unterschiedliche Kenngrößen wie Resonanzfrequenz oder statische Kapazität aufweisen.

Wahlweise können in der Signalleitung SL weitere passive Komponenten ein- oder angebunden sein. Möglich ist es beispielsweise, zwischen dem Filterport FP1 und dem ersten Schaltungsknoten SK1 eine Serieninduktivität LS einzubinden. Alternativ kann von einem Schaltungsknoten zwischen dem ersten Filterport FP1 und dem ersten seriellen Resonator RS1 eine Parallelspule LP gegen Masse geschaltet sein.

Auf der Seite des zweiten Filterports FP2 können entsprechend eine weitere Serienspule LS und/oder eine weitere Parallelspule LP vorgesehen sein.

Die Indizes n und m bestimmen den Kaskadierungsgrad der Verschaltung und können daher grundsätzlich ganzzahlige Werte von 1 bis ca. 10 annehmen. Prinzipiell sind auch höhere Werte für die Indizes n und m möglich, doch ist ein derartig hoher Kaskadierungsgrad wegen der dafür erforderlichen Fläche für die Filterschaltung wirtschaftlich und technisch nicht sinnvoll. n und m können unterschiedlich voneinander gewählt sein. In Figur 1A nicht dargestellt sind weitere Parallelzweige, die von weiteren Schaltungsknoten in der Signalleitung SL gegen Masse geschaltet sein können. Zwischen zwei solchen Schaltungsknoten SK können außerdem weitere Verschaltungen von Serienresonatoren vorgesehen sein.

Mit einer Filterschaltung gemäß Figur 1A wird gegenüber einer Filterschaltung ohne den ersten Kondensator K1 eine Reduzierung eines bestimmten Intermodulationsproduktes um 10 dB erzielt bzw. kann eine Verbesserung um 10 dB erzielt werden. In dieser und den folgenden Figuren wird auf die Darstellung weiterer Elemente verzichtet, die in der Filterschaltung vorhanden sein können, insbesondere weitere Parallelzweige, weitere serielle Resonatoren oder weitere Verschaltungen serieller Resonatoren. Auch Serien- und/oder Parallelinduktivitäten können in der Signalleitung vorgesehen sein oder an die Signalleitung angekoppelt sein.

Figur 1B zeigt eine weitere Filterschaltung, bei der im Unterschied zu Figur 1A innerhalb des ersten Parallelzweigs PZ1 ein erster Kondensator K1 nicht in Serie der Verschaltung von Parallelresonatoren VRP1, sondern parallel zu dieser geschaltet ist. Mithin verbindet dieser parallel geschaltete erste Kondensator K1 den Schaltungsknoten in der Signalleitung mit dem Festpotenzial. Auch in dieser Filterschaltung werden Intermodulationsprodukte um bis zu 10 dB gedämpft.

Figur 1C zeigt eine weitere Filterschaltung, die ähnlich wie Figur 1A ausgebildet ist, bei der jedoch ein zweiter Kondensator K2 im Serienzweig SL verschaltet ist, hier zwischen dem ersten Schaltungsknoten SK1, von dem der erste Parallelzweig PZ1 abzweigt, und der ersten Verschaltung serieller Resonatoren VRS1. Auch mit diesem zweiten Kondensator K2 allein, der als Spannungsteiler in der Signalleitung dient, wird die Linearität der Filterschaltung gegenüber bekannten Filterschaltungen mit gleicher Anzahl an Resonatoren RS,RP aber ohne Kondensator erhöht. Ansonsten gelten für mögliche Erweiterungen dieser Struktur die gleichen Möglichkeiten, wie sie anhand von Figur 1A und 1B angeführt wurden.

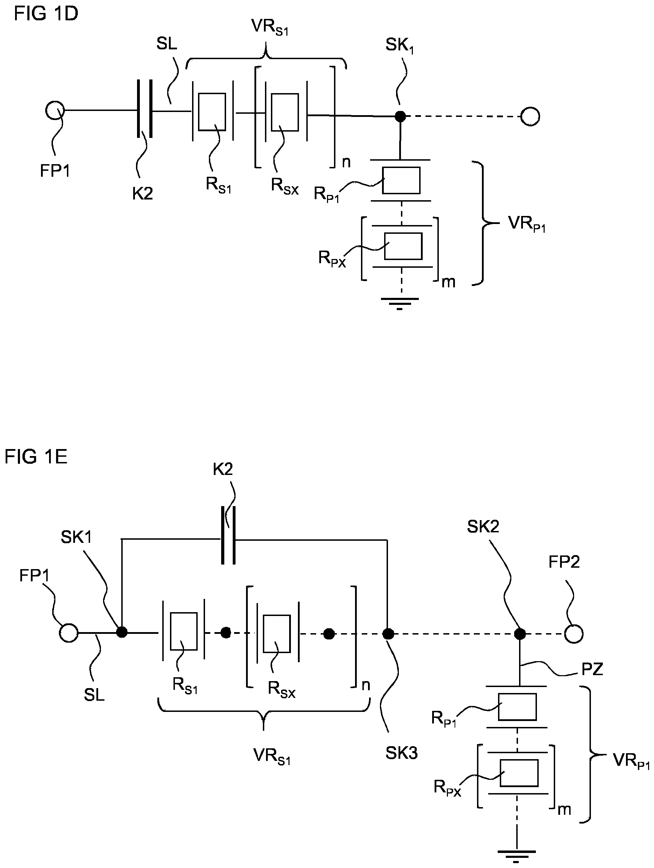

Figur 1D zeigt eine Filterschaltung ähnlich wie Figur 1C, bei der der erste Schaltungsknoten SK1 in der Signalleitung SL hinter dem ersten Resonator RS1 bzw. der ersten Verschaltung serieller Resonatoren VRS1 angeordnet ist und der zweite Kondensator K2 zwischen dem ersten Resonator RS1 bzw. der ersten Verschaltung VRS und dem ersten Filterport FP1 vorgesehen ist. Zwischen erstem Schaltungsknoten SK1 und zweiten Filterport FP2 können weitere Verschaltungen VRS von seriellen Resonatoren vorgesehen sein. Ebenso können weitere Schaltungsknoten SK vorgesehen sein, an die weitere Parallelzweige PZ angebunden sind. Außerdem kann zwischen je zwei Schaltungsknoten ein weiterer serieller zweiter Kondensator K2 vorgesehen sein. Zwischen Festpotenzial und einer Verschaltung paralleler Resonatoren kann außerdem in jedem Parallelzweig ein weiterer erster Kondensator K1 vorgesehen sein.

Figur 1E zeigt eine Filterschaltung ähnlich der Figur 1D. Hier ist ein zweiter Kondensator K2 parallel zur ersten Verschaltung VRS serieller Resonatoren VRS angeordnet. Ein erster Parallelzweig PZ, der an einen ersten Schaltungsknoten SK1 angebunden ist, weist eine Verschaltung VRP1 paralleler Resonatoren auf. Zwischen der ersten Verschaltung serieller Resonatoren VRS1 und dem zweiten Filterport FP2 kann zumindest eine weitere Verschaltung serieller Resonatoren VRS vorgesehen sein. An Schaltungsknoten SK beiderseits der Verschaltung serieller Resonatoren VRS kann je ein Parallelzweig angebunden sein.

Auch in dieser Filterschaltung, in der der zweite Kondensator K2 für eine Stromteilung in der seriellen Signalleitung sorgt, wird die Linearität der Filterschaltung erhöht und dadurch das Auftreten von Intermodulationsprodukten/Harmonischen vermindert.

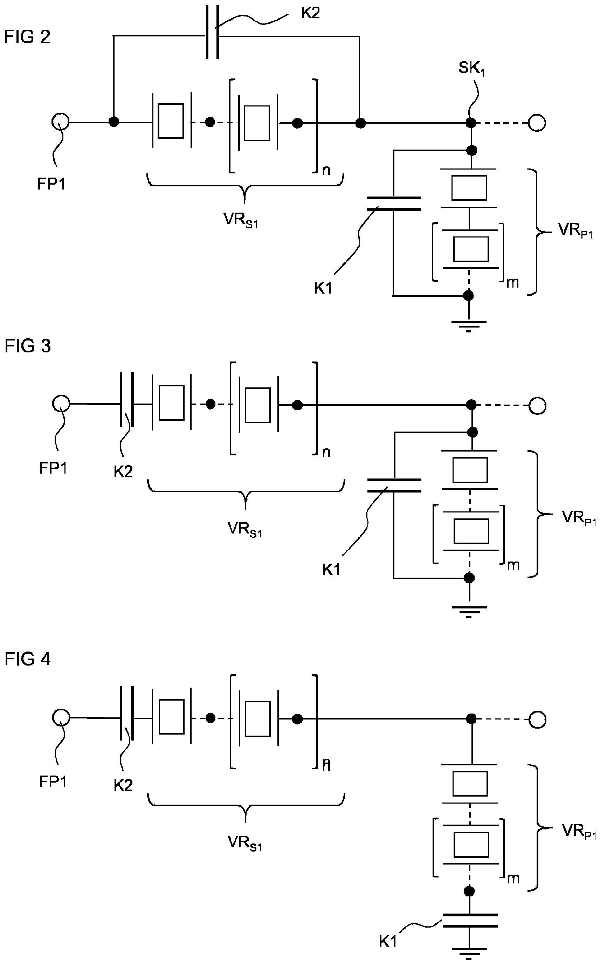

Figur 2 zeigt eine Filterschaltung, bei der parallel zu einer Verschaltung von parallelen Resonatoren VRP ein erster Kondensator K1 geschaltet ist und bei der parallel zu einer Verschaltung von seriellen Resonatoren VRS ein zweiter Kondensator K2 geschaltet ist. Es sind sowohl die Verschaltung von seriellen Resonatoren in der Signalleitung VRS1 als auch die Verschaltung paralleler Resonatoren SRP im ersten Parallelzweig PZ1 mit je einem Kondensator K1,K2 überbrückt.

Figur 3 zeigt eine Filterschaltung, bei der ein in der Signalleitung SL vorgesehener zweiter Kondensator K2 und ein parallel zum ersten Parallelzweig PZ1 geschalteter erster Kondensator K1 verschaltet sind. Die Filterschaltung kann weitere serielle Resonatoren oder weitere Verschaltungen serieller Resonatoren sowie weitere Parallelzweige, in denen weitere Resonatoren oder weitere Verschaltungen von Parallelresonatoren angeordnet sind, umfassen.

Figur 4 zeigt eine Filterschaltung ähnlich wie Figur 3, bei der jedoch der erste Kondensator K1 seriell zu einem Parallelresonator RP oder zu einer Verschaltung paralleler Resonatoren VRP angeordnet ist.

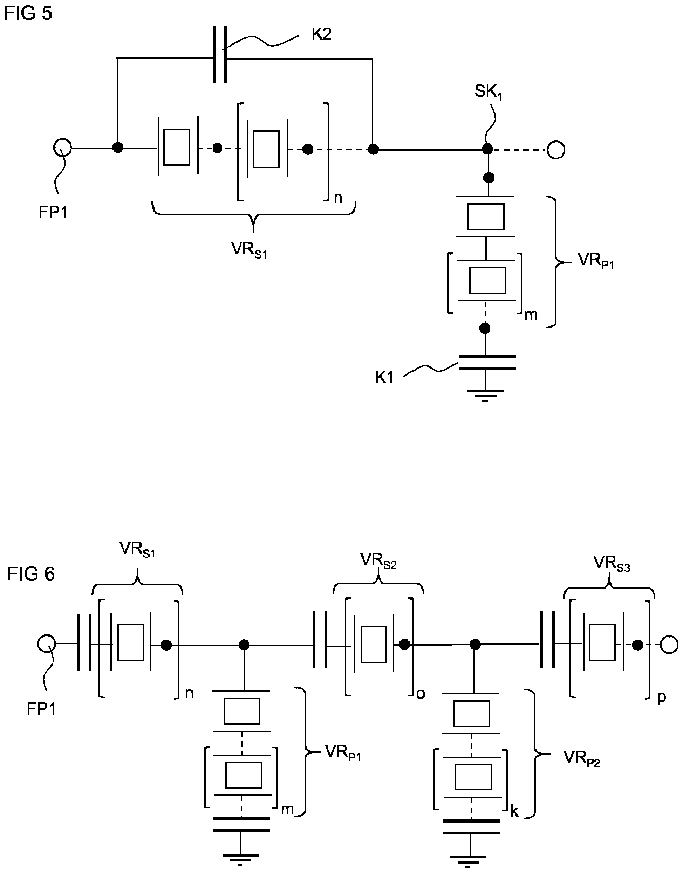

Figur 5 zeigt eine Filterschaltung ähnlich wie Figur 2, bei der jedoch der erste Kondensator K1 in Serie zu einem Parallelresonator RP oder zu einer Verschaltungen paralleler Resonatoren VRP angeordnet ist.

Eine nicht dargestellte Filterschaltung beginnt mit einem Parallelzweig, während die Figuren 1D bis 6 alle mit einem Serienresonator oder einer Verschaltung von Serienresonatoren beginnen. "Beginnen mit" bezieht sich dabei auf den Resonator, der dem als Eingang dienenden Filterport am nächsten gelegen ist

Figur 6 zeigt eine Filterschaltung, bei der drei Verschaltungen serieller Resonatoren VRS in der Signalleitung SL angeordnet sind. Zwischen je zwei solcher Verschaltungen ist ein Schaltungsknoten SK vorgesehen, von dem je ein Parallelzweig PZ mit einer darin angeordneten Verschaltung paralleler Resonatoren VRP vorgesehen ist.

Zwischen Filtereingang und erster Verschaltung serieller Resonatoren sowie zwischen erster und zweiter Verschaltung serieller Resonatoren sowie zwischen zweiter und dritter Verschaltung serieller Resonatoren ist je ein zweiter Kondensator K2 vorgesehen.

Von Schaltungsknoten zwischen je zwei seriellen Verschaltungen von Resonatoren VRS geht jeweils ein Parallelzweig PZ mit einer darin vorgesehenen Verschaltung paralleler Resonatoren VRP gegen Masse ab.

Die Indizes n, o, p, die den Kaskadierungsgrad der Verschaltung serieller Resonatoren VRS bezeichnen, sind individuell gewählt und können grundsätzlich Werte zwischen 1 und 10 annehmen. Die Indizes m, k geben den Kaskadierungsgrad der Verschaltungen paralleler Resonatoren VRP an. m nimmt hier Werte zwischen 4 und 8 an, k kann Werte zwischen 1 und 10 annehmen. Vorzugsweise wird der Kaskadierungsgrad serieller als auch paralleler Verschaltungen im unteren Bereich des Intervalls gewählt, sodass die entsprechenden Indizes vorzugsweise Werte zwischen 1 (bzw. 4) und 7, besser zwischen 1 (bzw. 4) und 5 aufweisen.

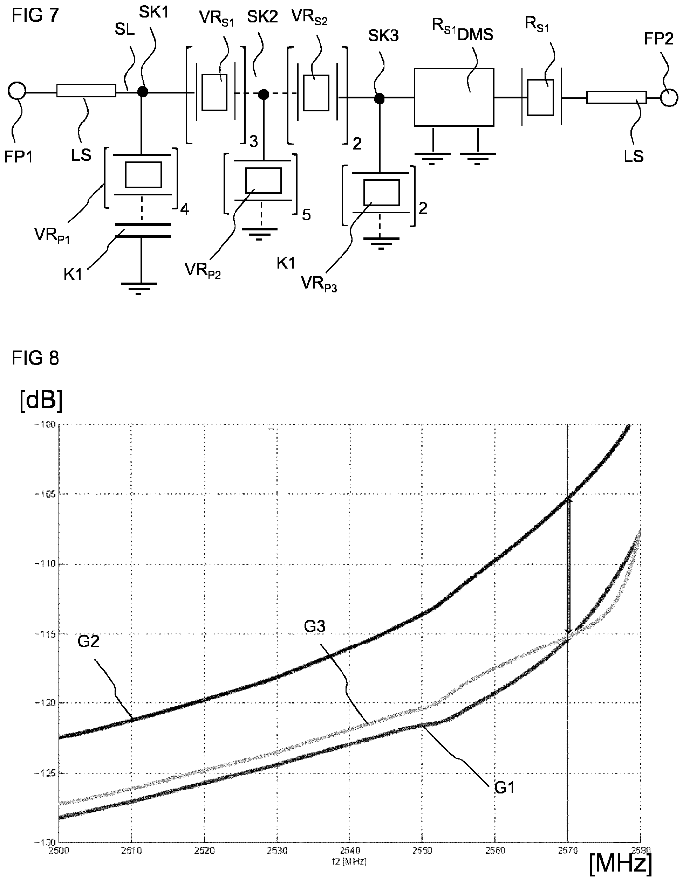

Figur 7 zeigt eine schematische Darstellung einer Filterschaltung, die für eine konkrete Schaltungsumgebung bzw. für bestimmte reale Systemanforderungen ausgelegt ist und die auf eine maximale Reduzierung von Intermodulationsprodukten ausgelegt ist. Die serielle Signalleitung SL weist hier beispielsweise drei Schaltungsknoten SK1, SK2, SK3 auf, von denen jeweils ein Parallelzweig PZ gegen Masse abgezweigt ist. Weiter ist in der Signalleitung nach dem dritten Parallelzweig ein DMS-Filter DMS in Serie geschaltet.

Zwischen dem zweiten und dritten Schaltungsknoten SK2,SK3 ist eine zweite serielle Verschaltung VRS2 serieller Resonatoren angeordnet. Zwischen DMS-Filter DMS und dem zweiten Filterport FP2 ist ein nicht kaskadierter Serienresonator RS1 vorgesehen.

Eine solche Filterschaltung ist beispielsweise auf ein nominelles Passband von 2620 bis 2630 MHz ausgelegt. Um dieses Filter, welches Teil einer Filterschaltung ist, mit einem nach der Stand der Technik konstruierten aber sonst möglichst ähnlichen Filter zu vergleichen, wurde ein Referenzfilter konstruiert, welches einen ersten Parallelzweig mit sieben verschalteten Parallelresonatoren, eine zweifach kaskadierte Verschaltung serieller Resonatoren, einen zweiten Parallelzweig mit zwei parallelen Resonatoren, einen seriellen Resonator, ein DMS-Filter, einen weiteren seriellen Resonator und eine zweifach kaskadierte Verschaltung zweier paralleler Resonatoren umfasst.

Im Vergleich des Filters gemäß Figur 7 und dem eben beschriebenen Referenzfilter zeigt sich, dass Lage und Bandbreite des Passbands in beiden Filtern praktisch gleich ist. Für das Filter gemäß Figur 7 zeichnen sich minimale Verschlechterungen bezüglich der Einfügedämpfung im Passband ab, dazu eine etwas verschlechterte Dämpfung im nahen Stoppband. Auch die Matrixparameter S11 und S22, die das Stehwellenverhältnis VSWR angeben, zeigen leicht verschlechterte Werte auf.

Ein beim Referenzfilter störendes Intermodulationprodukt dritter Ordnung, welches bei einer Frequenz von 2690 MHz auftritt, wird dagegen mit dem Filter gemäß Figur 7 um mehr als 10 dB reduziert. Da ansonsten die Filtereigenschaften praktisch unverändert bzw. nur unwesentlich verschlechtert sind, die Unterdrückung der Intermodulationsprodukte dagegen stark verbessert ist, zeigen sich deutlich die Vorteile, die erreicht werden können. Der Erfolg kann auch daran ersehen werden, dass eine vergleichbare Reduzierung von Intermodulationsprodukten bei einem Filter ohne zugeschaltete Kondensatoren erst mit einem Kaskadierungsgrad 13 für den ersten Parallelresonator erreicht wird. Ein so hoher Kaskadierungsgrad ist aufgrund der enormen zusätzlich notwendigen Fläche außerhalb jeder Diskussion und scheidet für realistische Anwendungen von vornherein aus. Mit dem Filter gemäß Figur 7 kann das gleiche Ergebnis auf wesentlich geringerer Fläche erzielt werden.

Figur 8 zeigt, wie mit einem wie in Figur 7 dargestellten Filter das Auftreten bzw. Verschwinden von störenden Intermodulationsprodukten in einfacher Weise nachgewiesen werden kann. Dazu wird beispielsweise an den Eingang des Filters von Figur 7 ein erster Störton in einem bestimmten Frequenzbereich f1 und einer Stärke von 10 dBm angelegt. Eine zweite Störfrequenz wird über einen Frequenzbereich f2 von 2500 bis 2570 MHz variiert und ebenfalls an den Filtereingang angelegt. Die Leistung dieses zweiten Störsignals beträgt 5 dBm.

Laut einer beispielhaften Systemanforderung muss ein Intermodulationsprodukt dritter Ordnung bei einer konstanten Frequenz $f_{IMD}$ = 2690 MHz = 2*f2-f1 bewertet werden. In der Figur 8 dargestellt ist ein erster Graph G1, der mit dem oben beschriebenen Verfahren an einem Filter gemäß Figur 7 gemessen wurde. Ein zweiter Graph G2 zeigt ein mit dem gleichen Verfahren getestetes vergleichbares Filter, das aber ohne den ersten Kondensator im ersten Parallelzweig ausgeführt ist. In der Figur ist die Dämpfung entsprechender Intermodulationsprodukte dritter Ordnung über der Frequenz aufgetragen.

Die Figur 8 zeigt, dass der Graph G1 für das Filter gemäß Figur 7 gegenüber dem zweiten Graph G2 eine um 10 dB verbesserte Unterdrückung des entstehenden Intermodulationsproduktes aufweist, insbesondere bei der kritischen Frequenz von 2570 MHz, bei der das Intermodulationsprodukt am größten ist. Ein dritter Graph G3 zeigt das Verhalten einer Filteranordnung, die ebenfalls ohne ersten Kondensator im ersten Parallelzweig ausgeführt ist, bei der aber die Anzahl der kaskadierten Parallelresonatoren so lange erhöht wurde, bis dieselbe Unterdrückung von Intermodulationsprodukten bei der betrachteten Frequenz von 2570 MHz erreicht ist. Es zeigt sich, dass dies erst mit einem Kaskadierungsgrad 13, also einer Serienverschaltung von 13 Parallelresonatoren der Fall ist.

Gegenüber dem Filter gemäß Figur 7 mit vier kaskadierten Parallelresonatoren im ersten Parallelzweig bedeutet dies eine wesentliche Reduzierung der erforderlichen Filterfläche. So habe das beschriebene Referenzfilter einen relativen akustischen Flächenbedarf von 1,0. Das Filter gemäß Figur 7 hat dann einen relativen akustischen Flächenbedarf von 1,6. Das Filter mit dem Kaskadierungsgrad 13 (entspricht Graph G3 in Fig. 8) hat dagegen einen relativen akustischen Flächenbedarf von 2,8. Gegenüber dem Filter gemäß Figur 7 als Referenz entspricht dies einem um den Faktor 1,8 erhöhten relativen akustischen Flächenbedarf. Oder noch anders gesagt kann mit dem Filter gemäß Figur 7 bei gleicher Unterdrückung der betrachteten $f_{IMD}$ eine Flächeneinsparung an akustischer Fläche um den Faktor 1,8 erzielt werden.

Es ist zu erwarten, dass in einer Filterschaltung auch mehr als zwei starke Störsignale vorkommen können. Die Standardisierung geht in eine Richtung, dass man z.B. mit bis zu vier gleichzeitig auftretenden starken Sendesignalen bei vier verschiedenen Frequenzen in einem Smartphone rechnen muss (2 x Cellular, 2 x WLAN). Dadurch kann dann eine Vielzahl weiterer möglicher nichtlinearer Mischprodukte entstehen, deren Frequenz in Empfangsbänder liegen und somit die Empfangsempfindlichkeit stark reduzieren können. Auch diese Vielzahl möglicher nichtlinearer Mischprodukte kann mit der Erfindung deutlich unterdrückt werden, die damit für alle diese Fälle ein Filter mit verbesserter Empfangsempfindlichkeit bereit stellt.

Wie bereits eingangs erwähnt, muss eine Veränderung im Kaskadierungsgrad mit einer Anpassung der statischen Kapazität der kaskadierten Resonatoren ausgeglichen werden. Für ein Filter wie beispielsweise in Figur 7 dargestellt, welches im ersten Parallelzweig vier in Serie geschaltete Parallelresonatoren und einen ersten Kondensator K1 aufweist, gilt, dass alle Resonatoren einer seriellen Verschaltung (Kaskade) von Serien- oder Parallelresonatoren vorteilhaft die gleiche statische Kapazität $C_{S,R}$ aufweisen.

Allgemein gilt: Werden m Resonatoren in Kaskade geschaltet so beträgt die statische Gesamtkapazität $C_{S,R,ges}$ der Kaskade $C_{S,R,ges} = C_{S,R}$ /m. Ein dazu in Reihe geschalteter Kondensator K sollte dann eine Kapazität $C_K$

$$C_K = a * C_{S,R,ges}$$

aufweisen, wobei a größer gleich 1 zu wählen ist.

Die Kapazität $C_{S,gesamt}$ aus Kaskade und Kondensator beträgt dann

$$C_{S,gesamt} = C_K /(a+1)$$

Für die Filterschaltungen, bei denen ein Kondensator parallel zu einer Kaskade von m Resonatoren mit je einer statischen Kapazität $C_{S,R}$ geschaltet wird, ergibt sich die statische Gesamtkapazität $C_{S,R,ges}$ der Kaskade wieder zu $C_{S,R}$ /m.

Ein parallel dazu geschalteter Kondensator K sollte dann eine Kapazität $C_K = b * C_{S,R,ges} = b/m * C_{S,R}$ aufweisen, wobei auch b größer gleich 1 zu wählen ist.

Die Kapazität $C_{S,gesamt}$ aus Kaskade und dazu parallelem Kondensator beträgt dann

$$C_{S,gesamt} = C_K * (1+b)/b$$

Zur Bemessung der Kapazitäten in einem Filter können zwei allgemeine Fälle A und B unterschieden werden, für die unterschiedliche vorteilhafte Bemessungen gelten.

Im Fall A beginne das Filter mit in Kaskade VRS geschalteten seriellen Resonatoren und einem dazu in Serie oder parallel geschalteten zweiten Kondensator K2. Auch der anschließende erste Parallelzweig PZ1 umfasst eine Kaskade VRP1 von Resonatoren, die in Serie zu einem ersten Kondensator K1 geschaltet sind. Im Serienzweig sind weitere in Kaskade VRS2 geschaltete serielle Resonatoren vorhanden. Zumindest ein weiterer Parallelzweig PZ umfasst eine weitere Kaskade VRP2 von Resonatoren.

Die Gesamtkapazitäten aller Parallelzweige des Laddertype-Filters oder -Unterfilters, ob mit oder ohne verschaltetem Kondensator, sind ungefähr gleich groß zu wählen. Eine Ausnahme bildet dabei nur der letzte Parallelzweig am zweiten Filterport FP2, bzw. dem Filterausgang. Der letzte Parallelzweig kann ein abschließender Parallelzweig sein. Dann folgt - in Signalrichtung gesehen - auch kein akustisches Element im Serienzweig mehr.

Die Gesamtkapazität der mit einem zweiten Kondensator verschalteten ersten Kaskade serieller Resonatoren inklusive Kondensator wird dann vorteilhaft ungefähr doppelt so hoch bemessen wie die Gesamtkapazität weiterer Kaskaden VRS2 im Serienzweig. Eine Ausnahme bildet dabei nur der letzte Serienresonator am zweiten Filterport FP2, bzw. dem Filterausgang. Der letzte Serienresorantor kann ein abschließender Serienresonator sein. Dann folgt - in Signalrichtung gesehen - auch kein akustisches Element in einem Parallelzweig mehr.

Im Fall B beginne das Filter mit einem Parallelzweig, der eine Kaskade VRP1 von Resonatoren, die in Serie oder parallel zu einem ersten Kondensator K1 geschaltet sind, umfasst. Danach folgen im Serienzweig in Kaskade VRS geschaltete serielle Resonatoren und einem dazu in Serie oder parallel geschalteten Kondensator K2. Im Serienzweig sind noch weitere in Kaskade VRS2 geschaltete serielle Resonatoren vorhanden. Zumindest ein weiterer Parallelzweig PZ umfasst eine Kaskade VRP2 von Resonatoren.

In diesem Fall gilt, dass die Gesamtkapazitäten aller Kaskaden des Laddertype-Filters oder -Unterfilters (mit oder ohne zweitem Kondensator) im Serienzweig ungefähr gleich zu wählen sind. Eine Ausnahme bildet dabei nur der letzte oder abschließende Serienresonator am zweiten Filterport FP2, bzw. dem Filterausgang. Die Gesamtkapazität der mit einem ersten Kondensator verschalteten ersten Kaskade paralleler Resonatoren VRP1 (inklusive Kondensator K1) wird dann vorteilhaft ungefähr halb so hoch bemessen wie die Gesamtkapazität weiterer Kaskaden VRP2 im Parallelzweig. Eine Ausnahme bildet dabei nur der letzte oder abschließende Parallelzweig am zweiten Filterport FP2, bzw. dem Filterausgang.

Begriffs- und Bezugszeichenliste

| | |
|---|---|
| F1 | erstes Filter |
| FP1 | erster Filterport, z.B. Filtereingang |
| FP2 | zweiter Filterport, z.B. Filterausgang |
| G1 | erster Graph |
| G2 | zweiter Graph |
| G3 | dritter Graph |
| K1 | erster Kondensator, im Parallelzweig |
| K2 | zweiter Kondensator, im seriellen Signalpfad |
| LP | Induktivität im Parallelzweig |
| LS | Induktivität im Signalpfad |
| PZ | Parallelzweig |
| RP | Resonatoren im Parallelzweig |
| RS | Resonatoren im seriellen Signalpfad |
| SK | Schaltungsknoten im Serienzweig, verbunden mit |
| SL | serieller Signalpfad, verbindet |
| VRP | Verschaltungen von Resonatoren im Parallelzweig |
| VRS | Verschaltungen von Resonatoren im seriellen Signalpfad |

**Patentansprüche**

1.  Filterschaltung

    - mit einem ersten Filter (F1),

        - bei dem ein serieller Signalpfad (SL) einen ersten Filterport (IN, FP1) mit einem zweiten Filterport (OUT, FP2) verbindet,
        - bei dem im seriellen Signalpfad (SL) Schaltungsknoten (SK) angeordnet sind, die über je einen Parallelzweig (PZ) mit einem Festpotential verbunden sind
        - bei dem im seriellen Signalpfad (SL) Serienresonatoren (RS) oder Verschaltungen (VRS) von Serienresonatoren (RS) angeordnet sind und in den Parallelzweigen Parallelresonatoren (RP) oder Verschaltungen (VRP) von Parallelresonatoren (RP) angeordnet sind
        - bei dem ein erster Parallelzweig (PZ1), der mit einem dem ersten Filterport (IN, FP1) am nächsten angeordneten ersten Schaltungsknoten verbunden ist, eine Serienverschaltung (VRP1) von 4 bis 8 besagter Parallelresonatoren (RP) umfasst
        - bei dem im seriellen Signalpfad (SL) zwischen dem ersten Filterport (IN, FP1) und dem ersten Schaltungsknoten eine erste Serienverschaltung (VRS1) von mehreren besagter Serienresonatoren (RS) angeordnet ist,
        - bei dem ein erster Kondensator (K1) in Serie zum ersten Parallelzweig (PZ1) und ein zweiter Kondensator (K2) in Serie oder parallel zur ersten Serienverschaltung (VRS1) der mehreren besagten Serienresonatoren (RS) verschaltet ist,

- bei der die Parallelzweige jeweils die gleiche Gesamtkapazität aufweisen, die sich aus der Kapazität der Verschaltung (VRP) von Parallelresonatoren (RP) und der des parallel oder in Reihe dazu geschalteten Kondensators ergibt,
- bei der der dem zweiten Filterport (OUT, FP2) am nächsten angeordnete Parallelzweig von dieser Regelung der Gesamtkapazitäten ausgenommen sein kann.

2. Filterschaltung nach Anspruch 1,
bei der die Serienresonatoren (RS) und Parallelresonatoren (RP) als mit akustischen Wellen arbeitende Resonatoren ausgelegt sind.

3. Filterschaltung nach einem der Ansprüche 1-2,
bei der im seriellen Signalpfad (SL) zwischen der ersten Serienverschaltung (VRS1) der mehreren besagten Serienresonatoren (RS) und dem ersten Filterport (IN, FP1) der zweite Kondensator (K2) verschaltet ist.

4. Filterschaltung nach einem der Ansprüche 1-3,

bei der das erste Filter (F1) ein Sende- oder Empfangsfilter ist,
bei der die Filterschaltung außerdem einen oder mehrere Empfangs- oder Sendezweige umfasst, die mit dem ersten (IN, FP1) oder zweiten Filterport (OUT, FP2) gekoppelt sind,
bei der die Sendezweige zum Senden in unterschiedlichen Sendebändern und die Empfangszweige zum Empfangen in unterschiedlichen Empfangsbändern ausgelegt sind.

5. Filterschaltung nach einem der Ansprüche 1 - 4,
bei der das erste Filter (F1) ein Empfangsfilter oder ein Sendefilter eines Duplexers ist.

6. Filterschaltung nach einem der Ansprüche 1 - 5,
bei der vor dem dem ersten Filterport (IN, FP1) am nächsten angeordneten Serienresonator (RS), nach dem dem zweiten Filterport (OUT, FP2) am nächsten angeordneten Serienresonator (RS) und zwischen allen im seriellen Signalpfad (SL) angeordneten Verschaltungen (VRS) von Serienresonatoren (RS) jeweils ein Kondensator angeordnet ist.

7. Filterschaltung nach einem der Ansprüche 1 - 6,
bei der ein DMS-Filter (DMS) im seriellen Signalpfad (SL) in Serie verschaltet ist.

8. Filterschaltung nach einem der Ansprüche 1 - 7,
ausgebildet als ein Chipbauelement,

- bei dem die Serienresonatoren (RS) und Parallelresonatoren (RP) als SAW-Eintorresonatoren ausgebildet sind,
- bei dem die Serienresonatoren (RS) und Parallelresonatoren (RP) auf einem gemeinsamen Chip angeordnet sind
- bei dem die Kondensatoren (K1, K2) auf dem Chip als Plattenkondensatoren realisiert sind, die jeweils zwei gegenüber einer Leiterbahn flächig ausgeformte Kondensatorelektroden und eine dazwischen angeordnete Dielektrikumsschicht aufweisen,
- bei dem die Dielektrikumsschicht zusammen mit einer weiteren Funktionsschicht des Chipbauelements in einem gemeinsamen Herstellungsschritt erzeugt sind und daher ein gleiches Material und eine gleiche Schichtdicke aufweisen
- bei dem eine untere Elektrode des Kondensators aus einer Metallisierung des Eintorresonators gebildet ist
- bei dem eine obere Elektrode des Kondensators zusammen mit einer Padaufdickung ausgebildet ist, die über einem Anschlusspad des Filters erzeugt ist.

9. Filterschaltung nach Anspruch 8,
wobei die Dielektrikumsschicht zwischen den Kondensatorelektroden zusammen mit einer Isolationsschicht erzeugt ist, die zur Isolation zwischen sich kreuzenden Leiterbahnabschnitten der Filterschaltung eingesetzt ist.

10. Filterschaltung nach Anspruch 8,

wobei als Dielektrikumsschicht zwischen den Kondensatorelektroden eine ganzflächig aufgebrachte Schicht zur Verminderung eines Temperaturkoeffizienten der Filterschaltung dient, die ein Material mit positivem Temperaturkoeffizienten seiner mechanischen Eigenschaften, insbesondere der Steifigkeit, aufweist, wobei im Bereich der Kondensatoren abschließend die obere Kondensatorelektrode über der Dielektrikumsschicht aufgebracht wird.

11. Filterschaltung nach einem der Ansprüche 1 - 7,
wobei die Kondensatoren nicht auf einem die Laddertypeschaltung des ersten Filters tragenden Chip angeordnet sind, sondern in eine LTCC oder in ein Laminat integriert sind oder als externe diskrete Kondensatoren ausgeführt sind.

12. Filterschaltung nach einem der Ansprüche 1 - 11,

bei der die Verschaltungen (VRS) mehrerer besagter Serienresonatoren (RS) und/oder die Verschaltungen (VRP) mehrerer besagter Parallelresonatoren (RP) kaskadierte Serienresonatoren (RS) und/oder Parallelresonatoren (RP) umfassen,
bei der ein Kaskadierungsgrad der Serienresonatoren (RS) und/oder Parallelresonatoren (RP) in der Filterschaltung mit zunehmender Entfernung vom ersten Filterport (IN, FP1) abnimmt.

**Claims**

1. Filter circuit

   - with a first filter (F1),

     - in which a serial signal path (SL) connects a first filter port (IN, FP1) to a second filter port (OUT, FP2),
     - in which circuit nodes (SK) are arranged in the serial signal path (SL), which circuit nodes are each connected to a fixed potential via a parallel branch (PZ),
     - in which series resonators (RS) or interconnections (VRS) of series resonators (RS) are arranged in the serial signal path (SL), and parallel resonators (RP) or interconnections (VRP) of parallel resonators (RP) are arranged in the parallel branches,
     - in which a first parallel branch (PZ1), which is connected to a first circuit node arranged closest to the first filter port (IN, FP1), comprises a series interconnection (VRP1) of 4 to 8 of said parallel resonators (RP),
     - in which a first series interconnection (VRS1) of a plurality of said series resonators (RS) is arranged in the serial signal path (SL) between the first filter port (IN, FP1) and the first circuit node,
     - in which a first capacitor (K1) is connected in series with the first parallel branch (PZ1) and a second capacitor (K2) is connected in series or in parallel with the first series interconnection (VRS1) of the plurality of said series resonators (RS),

   - in which the parallel branches each have the same total capacitance, which results from the capacitance of the interconnection (VRP) of parallel resonators (RP) and that of the capacitor connected in parallel or in series therewith,
   - in which the parallel branch arranged closest to the second filter port (OUT, FP2) can be excluded from this regulation of the total capacitances.

2. Filter circuit according to claim 1,
in which the series resonators (RS) and parallel resonators (RP) are designed as resonators operating with acoustic waves.

3. Filter circuit according to one of claims 1 - 2,
in which the second capacitor (K2) is connected in the serial signal path (SL) between the first series interconnection (VRS1) of the plurality of said series resonators (RS) and the first filter port (IN, FP1).

4. Filter circuit according to one of claims 1 - 3,

in which the first filter (F1) is a transmitting or receiving filter,
in which the filter circuit further comprises one or more receiving or transmitting branches which are coupled to the first (IN, FP1) or second filter port (OUT, FP2),

in which the transmitting branches are designed to transmit in different transmitting bands and the receiving branches are designed to receive in different receiving bands.

**5.** Filter circuit according to one of claims 1 - 4,
in which the first filter (F1) is a receiving filter or a transmitting filter of a duplexer.

**6.** Filter circuit according to one of claims 1 - 5,
in which a capacitor is arranged in each case before the series resonator (RS) arranged closest to the first filter port (IN, FP1), after the series resonator (RS) arranged closest to the second filter port (OUT, FP2) and between all interconnections (VRS) of series resonators (RS) arranged in the serial signal path (SL).

**7.** Filter circuit according to one of claims 1 - 6,
in which a DMS filter (DMS) is connected in series in the serial signal path (SL).

**8.** Filter circuit according to one of claims 1 - 7,
designed as a chip component,

- in which the series resonators (RS) and parallel resonators (RP) are designed as SAW input resonators,
- in which the series resonators (RS) and parallel resonators (RP) are arranged on a common chip,
- in which the capacitors (K1, K2) on the chip are realised as plate capacitors, which each have two capacitor electrodes formed flat with respect to a strip conductor and a dielectric layer arranged in between,
- in which the dielectric layer together with a further functional layer of the chip component are produced in a common production step and therefore have an identical material and an identical layer thickness,
- in which a lower electrode of the capacitor is formed from a metallization of the input resonator,
- in which an upper electrode of the capacitor is formed together with a pad thickening, which is produced above a connection pad of the filter.

**9.** Filter circuit according to claim 8,
wherein the dielectric layer between the capacitor electrodes is produced together with an insulation layer, which is used for insulation between crossing strip conductor sections of the filter circuit.

**10.** Filter circuit according to claim 8,
wherein a layer applied over the entire surface serves as the dielectric layer between the capacitor electrodes for reducing a temperature coefficient of the filter circuit, which layer has a material with a positive temperature coefficient of its mechanical properties, in particular of the stiffness, wherein the upper capacitor electrode is finally applied above the dielectric layer in the region of the capacitors.

**11.** Filter circuit according to one of claims 1 - 7,
wherein the capacitors are not arranged on a chip carrying the ladder-type-circuit of the first filter, but are integrated into an LTCC or into a laminate or are designed as external discrete capacitors.

**12.** Filter circuit according to one of claims 1 - 11,

in which the interconnections (VRS) of a plurality of said series resonators (RS) and/or the interconnections (VRP) of a plurality of said parallel resonators (RP) comprise cascaded series resonators (RS) and/or parallel resonators (RP),
in which a degree of cascading of the series resonators (RS) and/or parallel resonators (RP) in the filter circuit decreases with increasing distance from the first filter port (IN, FP1).

**Revendications**

**1.** Circuit de filtrage

- avec un premier filtre (F1)

- dans lequel un trajet de signal série (SL) relie un premier port du filtre (IN, FP1) à un second port du filtre (OUT, FP2),

- dans lequel sont disposés dans le trajet de signal série (SL) des noeuds de circuit (SK) qui sont reliés chacun à un potentiel fixe par l'intermédiaire d'une branche parallèle (PZ),
- dans lequel sont disposés dans le trajet de signal série (SL) des résonateurs série (RS) ou des circuiteries (VRS) de résonateurs série (RS), et sont disposés dans les branches parallèles des résonateurs parallèles (RP) ou des circuiteries (VRP) de résonateurs parallèles (RP),
- dans lequel une première branche parallèle (PZ1), reliée à un premier noeud de circuit disposé le plus près du premier port du filtre (IN, FP1), comprend une circuiterie série (VRP1) de 4 à 8 desdits résonateurs parallèles (RP),
- dans lequel est disposée dans le trajet de signal série (SL), entre le premier port du filtre (IN, FP1) et le premier noeud de circuit, une première circuiterie série (VRS1) de plusieurs desdits résonateurs série (RS),
- dans lequel un premier condensateur (K1) est monté en série avec la première branche parallèle (PZ1), et un second condensateur (K2) est monté en série ou en parallèle avec la première circuiterie série (VRS1) de plusieurs desdits résonateurs série (RS),

- dans lequel les branches parallèles présentent respectivement la même capacité totale que celle qui est obtenue avec la capacité de la circuiterie (VRP) de résonateurs parallèles (RP) et celle du condensateur qui y est relié en parallèle ou en série,
- dans lequel la branche parallèle disposée le plus près du second port du filtre (OUT, FP2) peut être exclue de cette règle des capacités totales.

2. Circuit de filtrage selon la revendication 1,
dans lequel les résonateurs série (RS) et les résonateurs parallèles (RP) sont réalisés en résonateurs à ondes acoustiques.

3. Circuit de filtrage selon une des revendications 1 à 2,
dans lequel, dans le trajet de signal série (SL), le second condensateur (K2) est monté entre la première circuiterie série (VRS1) de plusieurs desdits résonateurs série (RS) et le premier port du filtre (IN, FP1).

4. Circuit de filtrage selon une des revendications 1 à 3,

dans lequel le premier filtre (F1) est un filtre d'émission ou de réception,
dans lequel le circuit de filtrage comprend en outre une ou plusieurs branches de réception ou d'émission qui sont couplées au premier (IN, FP1) ou au second port du filtre (OUT, FP2),
dans lequel les branches d'émission sont conçues pour émettre dans diverses bandes d'émission et les branches de réception sont conçues pour recevoir dans diverses bandes de réception.

5. Circuit de filtrage selon une des revendications 1 à 4,
dans lequel le premier filtre (F1) est un filtre de réception ou un filtre d'émission d'un duplexeur.

6. Circuit de filtrage selon une des revendications 1 à 5,
dans lequel il est prévu un condensateur, respectivement, avant le résonateur série (RS) disposé le plus près du premier port du filtre (IN, FP1), après le résonateur série (RS) disposé le plus près du second port du filtre (OUT, FP2), et entre toutes les circuiteries (VRS) de résonateurs série (RS) disposées dans le trajet de signal série (SL).

7. Circuit de filtrage selon une des revendications 1 à 6,
dans lequel un filtre DMS (DMS) est monté en série dans le trajet de signal série (SL).

8. Circuit de filtrage selon une des revendications 1 à 7,
conformé en composant de puce,

- dans lequel les résonateurs série (RS) et les résonateurs parallèles (RP) sont réalisés en résonateurs SAW à port unique,
- dans lequel les résonateurs série (RS) et les résonateurs parallèles (RP) sont situés sur une puce commune,
- dans lequel les condensateurs (K1, K2) sont réalisés sur la puce sous la forme de condensateurs plans avec respectivement deux électrodes de condensateur conformées plates et une couche de diélectrique disposée entre elles,
- dans lequel la couche de diélectrique est générée dans une étape de fabrication commune en même temps qu'une autre couche fonctionnelle du composant de puce, avec ainsi un même matériau et une même épaisseur de couche,

- dans lequel une électrode inférieure du condensateur est réalisée par une métallisation du résonateur à port unique,
- dans lequel une électrode supérieure du condensateur est réalisée en même temps qu'un épaississement d'une plage de contact qui est formé sur une plage de contact de connexion du filtre.

**9.** Circuit de filtrage selon la revendication 8, dans lequel la couche de diélectrique est formée entre les électrodes de condensateur en même temps qu'une couche isolante qui assure un isolement entre des portions de pistes conductrices du circuit de filtrage qui se croisent.

**10.** Circuit de filtrage selon la revendication 8, dans lequel est utilisée comme couche de diélectrique entre les électrodes de condensateur une couche présente sur toute la surface pour abaisser un coefficient de température du circuit de filtrage, laquelle comprend un matériau avec des coefficients de température positifs pour ses propriétés mécaniques, en particulier la rigidité, l'électrode supérieure de condensateur étant finalement appliquée sur la couche de diélectrique dans la région des condensateurs.

**11.** Circuit de filtrage selon une des revendications 1 à 7,
dans lequel les condensateurs ne sont pas disposés sur une puce portant le circuit en échelle du premier filtre, mais intégrés dans une LTCC ou dans un laminé ou conformés en condensateurs externes discrets.

**12.** Circuit de filtrage selon une des revendications 1 à 11,

dans lequel les circuiteries (VRS) de plusieurs desdits résonateurs série (RS) et/ou les circuiteries (VRP) de plusieurs desdits résonateurs parallèles (RP) comprennent des résonateurs série (RS) et/ou des résonateurs parallèles (RP) en cascade,
dans lequel le niveau de montage en cascade des résonateurs série (RS) et/ou des résonateurs parallèles (RP) dans le circuit de filtrage diminue à mesure qu'augmente l'éloignement par rapport au premier port du filtre (IN, FP1).

FIG 1A

VR$_{S1}$

SL          SK$_1$

PZ1

FP1    L$_S$

L$_P$

R$_{P1}$

R$_S$    R$_{SX}$    FP2

R$_{PX}$

VR$_{P1}$

K1

F1

$n$    $m$

FIG 1B

VR$_{S1}$

SL

R$_{P1}$

R$_S$

FP1

VR$_{P1}$

K1

FP2

$n$    $m$

FIG 1C

K2    VR$_{S1}$

SL    SK$_1$

FP1

R$_{P1}$

R$_{S1}$

VR$_{P1}$

$n$    $m$

FIG 1D

FIG 1E

FIG 2

K2

SK$_1$

FP1

VR$_{S1}$

n

K1

VR$_{P1}$

m

FIG 3

FP1

K2

VR$_{S1}$

n

K1

VR$_{P1}$

m

FIG 4

FP1

K2

VR$_{S1}$

n

K1

VR$_{P1}$

m

FIG 5

FIG 6

FIG 7

FIG 8

FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1478091 A2
- WO 2010100148 A1
- EP 2141805 A2
- US 8310321 B2
- US 8701065 B1
- EP 1209807 A2
- US 20020140519 A1
- EP 1544997 A2